# EUROPEAN PATENT APPLICATION

(11) **EP 3 533 843 A1**
(43) Date of publication of application: **04.09.2019**
(21) Application number: 19160389.3
(22) Date of filing: 01.03.2019
(51) Int. Cl.: C09D 11/037, C09D 11/101, C09D 11/12

(54) **DIGITAL OFFSET LITHOGRAPHY INK COMPOSITION**

(30) Priority: 02.03.2018 US 201815910512
(71) Applicant: Xerox Corporation, Webster, NY 14580 (US)
(72) Inventor: ALLEN, C. Geoffrey, Waterdown, Ontario L8B 0P1 (CA); MOORLAG, Carolyn, Mississauga, Ontario L5G 4A7 (CA); MAGDALINIS, Aurelian Valeriu, Newmarket, Ontario L3X 2X3 (CA); ABRAHAM, Biby Esther, Mississauga, Ontario L5M 7E2 (CA); LEE, Jonathan Siu-Chung, Oakville, Ontario L6H 4K4 (CA)
(74) Representative: Lord, Michael

(57) **Abstract**

An ink composition for use in digital offset printing including at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C. A process of digital offset printing including applying the ink composition onto a re-imageable imaging member surface at an ink take up temperature, the re-imageable imaging member having dampening fluid disposed thereon; forming an ink image; transferring the ink image from the re-imageable surface of the imaging member to a printable substrate at an ink transfer temperature.

## Description

Disclosed herein is an ink composition for use in digital offset printing, comprising at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C.

Further disclosed is a process of digital offset printing, the process comprising applying an ink composition onto a re-imageable imaging member surface at an ink take up temperature, the re-imageable imaging member having dampening fluid disposed thereon; forming an ink image; transferring the ink image from the re-imageable surface of the imaging member to a printable substrate at an ink transfer temperature; wherein the ink composition comprises at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C.

Further disclosed is a process comprising combining at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C; optionally, heating; and optionally, filtering; to provide an ink composition.

DALI (Digital Architecture for Lithographic Inks) inks are offset type inks that are specifically designed and optimized to be compatible with the different indirect printing subsystems, including ink delivery subsystem, imaging subsystem, and cleaning subsystem, that enable high quality printing at high speed. Beyond having reliable inks, it is desirable that the resultant radiation cured prints prepared with these inks have reliable robustness properties including good chemical resistance and adhesion to the substrate even when having been cured at speeds of 1 meter/second or greater.

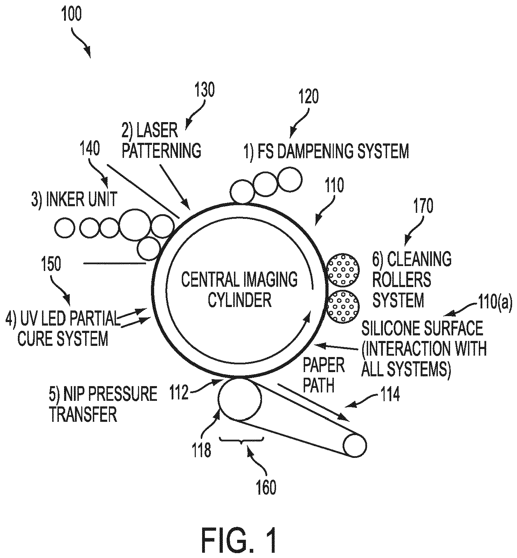

An exemplary digital offset printing architecture is shown in FIG. 1. As seen in FIG. 1, an exemplary system 100 may include an imaging member 110. The imaging member 110 in the embodiment shown in FIG. 1 is a drum, but this exemplary depiction should not be interpreted so as to exclude embodiments wherein the imaging member 110 includes a plate or a belt, or another now known or later developed configuration. The re-imageable surface 110(a) may be formed of materials including, for example, a class of materials commonly referred to as silicones, including fluorosilicone, among others. The re-imageable surface may be formed of a relatively thin layer over a mounting layer, a thickness of the relatively thin layer being selected to balance printing or marking performance, durability and manufacturability.

U.S. Publication No. 20120103212 ("212 Publication"), entitled "Variable Data Lithography System," filed on April 27, 2011, by Timothy Stowe et al., which is commonly assigned, and the disclosure of which is hereby incorporated by reference herein in its entirety, depicts details of the imaging member 110 including the imaging member 110 being comprised of a re-imageable surface layer 110(a) formed over a structural mounting layer that may be, for example, a cylindrical core, or one or more structural layers over a cylindrical core.

The imaging member 110 is used to apply an ink image to an image receiving media substrate 114 at a transfer nip 112. The transfer nip 112 is formed by an impression roller 118, as part of an image transfer mechanism 160, exerting pressure in the direction of the imaging member 110. Image receiving medium substrate 114 includes, but is not limited to, any particular composition or form such as, for example, paper, plastic, folded paperboard, Kraft paper, clear substrates, metallic substrates or labels. The exemplary system 100 may be used for producing images on a wide variety of image receiving media substrates. The 212 Publication also explains the wide latitude of marking (printing) materials that may be used.

The exemplary system 100 includes a dampening fluid system 120 (FS Dampening System) generally comprising a series of rollers, which may be considered as dampening rollers or a dampening unit, for uniformly wetting the re-imageable surface of the imaging member 110 with dampening fluid. A purpose of the dampening fluid system 120 is to deliver a layer of dampening fluid, generally having a uniform and controlled thickness, to the re-imageable surface of the imaging member 110. It is known that a dampening fluid such as fountain solution may comprise mainly water optionally with small amounts of isopropyl alcohol or ethanol added to reduce surface tension as well as to lower evaporation energy necessary to support subsequent laser patterning, as will be described in greater detail below. Small amounts of certain surfactants may be added to the fountain solution as well. Alternatively, other suitable dampening fluids may be used to enhance the performance of ink based digital lithography systems. Exemplary dampening fluids include water, Novec™ 7600 (1,1,1,2,3,3-Hexafluoro-4-(1,1,2,3,3,3-hexafluoropropoxy)pentane.), and D4 (octamethylcyclotetrasiloxane). Other suitable dampening fluids are disclosed, by way of example, in U.S. Patent 9,592,699, the disclosure of which is hereby incorporated herein by reference in its entirety.

Once the dampening fluid is metered onto the re-imageable surface of the imaging member 110, a thickness of the dampening fluid may be measured using a sensor (not shown) that may provide feedback to control the metering of the dampening fluid onto the re-imageable surface of the imaging member 110 by the dampening fluid system 120.

After a precise and uniform amount of dampening fluid is provided by the dampening fluid system 120 on the re-imageable surface of the imaging member 110, an optical patterning subsystem 130 may be used to selectively form a latent image in the uniform dampening fluid layer by image-wise patterning the dampening fluid layer using, for example, laser energy. Typically, the dampening fluid will not absorb the optical energy (IR or visible) efficiently. The re-imageable surface of the imaging member 110 should ideally absorb most of the laser energy (visible or invisible such as IR) emitted from the optical patterning subsystem 130 close to the surface to minimize energy wasted in heating the dampening fluid and to minimize lateral spreading of heat in order to maintain a high spatial resolution capability. Alternatively, an appropriate radiation sensitive component may be added to the dampening fluid to aid in the absorption of the incident radiant laser energy. While the optical patterning subsystem 130 is described above as being a laser emitter, it should be understood that a variety of different systems may be used to deliver the optical energy to pattern the dampening fluid.

The mechanics at work in the patterning process undertaken by the optical patterning subsystem 130 of the exemplary system 100 are described in detail with reference to FIG. 5 in the 212 Publication. Briefly, the publication of optical patterning energy from the optical patterning subsystem 130 results in selective removal of portions of the layer of dampening fluid.

Following patterning of the dampening fluid layer by the optical patterning subsystem 130, the patterned layer over the re-imageable surface of the imaging member 110 is presented to an inker subsystem 140. The inker subsystem 140 is used to apply a uniform layer of ink over the layer of dampening fluid and the re-imageable surface layer of the imaging member 110. The inker subsystem 140 may use an anilox roller to meter an offset lithographic ink, such as the ink compositions of the present disclosure, onto one or more ink forming rollers that are in contact with the re-imageable surface layer of the imaging member 110. Separately, the inker subsystem 140 may include other traditional elements such as a series of metering rollers to provide a precise feed rate of ink to the re-imageable surface. The inker subsystem 140 may deposit the ink to the pockets representing the imaged portions of the re-imageable surface, while ink on the unformatted portions of the dampening fluid will not adhere to those portions.

The cohesiveness and viscosity of the ink residing in the re-imageable layer of the imaging member 110 may be modified by a number of mechanisms. One such mechanism may involve the use of a rheology (complex viscoelastic modulus) control subsystem 150 (for example, a UV LED partial cure system). The rheology control system 150 may form a partial crosslinking layer of the ink on the re-imageable surface to, for example, increase ink cohesive strength relative to the re-imageable surface layer. Curing mechanisms may include optical or photo curing, heat curing, drying, or various forms of chemical curing. Cooling may be used to modify rheology as well via multiple physical cooling mechanisms, as well as via chemical cooling.

The ink is then transferred from the re-imageable surface of the imaging member 110 to a substrate of image receiving medium 114 using a transfer subsystem 160. The transfer occurs as the substrate 114 is passed through a nip 112 between the imaging member 110 and an impression roller 118 such that the ink within the voids of the re-imageable surface of the imaging member 110 is brought into physical contact with the substrate 114. With the adhesion of the ink, such as the ink of the present disclosure, having been modified by the rheology control system 150, modified adhesion of the ink causes the ink to adhere to the substrate 114 and to separate from the re-imageable surface of the imaging member 110. Careful control of the temperature and pressure conditions at the transfer nip 112 may allow transfer efficiencies for the ink, such as the ink of the present disclosure, from the re-imageable surface of the imaging member 110 to the substrate 114 to exceed 95%. While it is possible that some dampening fluid may also wet substrate 114, the volume of such a dampening fluid may be minimal, and may rapidly evaporate or be absorbed by the substrate 114.

In certain offset lithographic systems, it should be recognized that an offset roller, not shown in FIG.1, may first receive the ink image pattern and then transfer the ink image pattern to a substrate according to a known indirect transfer method.

Following the transfer of the majority of the ink to the substrate 114, any residual ink and/or residual dampening fluid may be removed from the re-imageable surface of the imaging member 110, typically without scraping or wearing that surface. An air knife may be employed to remove residual dampening fluid. It is anticipated, however, that some amount of ink residue may remain. Removal of such remaining ink residue may be accomplished through use of some form of cleaning subsystem 170. The 212 Publication describes details of such a cleaning subsystem 170 including at least a first cleaning member such as a sticky or tacky member in physical contact with the re-imageable surface of the imaging member 110, the sticky or tacky member removing residual ink and any remaining small amounts of surfactant compounds from the dampening fluid of the re-imageable surface of the imaging member 110. The sticky or tacky member may then be brought into contact with a smooth roller to which residual ink may be transferred from the sticky or tacky member, the ink being subsequently stripped from the smooth roller by, for example, a doctor blade.

The 212 Publication details other mechanisms by which cleaning of the re-imageable surface of the imaging member 110 may be facilitated. Regardless of the cleaning mechanism, however, cleaning of the residual ink and dampening fluid from the re-imageable surface of the imaging member 110 may be used to prevent ghosting in the system. Once cleaned, the re-imageable surface of the imaging member 110 is again presented to the dampening fluid system 120 by which a fresh layer of dampening fluid is supplied to the re-imageable surface of the imaging member 110, and the process is repeated.

In embodiments, a digital offset printing process involves the transfer of a pigmented UV (ultra violet) curable ink onto a fluorosilicone printing plate which has been partially coated with a release agent or fountain solution, such as is commercially sold as D4. The ink is then optionally subjected to partial cure using UV light and transferred from the plate to the object, which can be made from paper, plastic or metal, being printed. The ink on the object is again exposed to UV light for final curing of the ink.

In order to meet digital offset printing requirements, the ink desirably possesses many physical and chemical properties. The ink is desirably compatible with materials it is in contact with, including printing plate, fountain solution, and other cured or non-cured inks. It also desirably meets functional requirements of the sub-systems, including wetting and transfer properties. Transfer of the imaged inks is challenging, as the ink desirably possesses the combination of wetting and transfer traits, that is, the ink desirably at once wets the blanket material homogeneously, and transfers from the blanket to the substrate. Transfer of the image layer is desirably efficient, desirably at least as high as 90%, as the cleaning substation can only eliminate small amounts of residual ink. Any ink remaining on the blanket after cleaning can result in an unacceptable ghost image appearing in subsequent prints. Not surprisingly, ink rheology can play a key role in the transfer characteristics of an ink.

The DALI ink further desirably meets functional requirements of the sub-systems including possessing desired wetting and transfer properties. Thus, DALI inks are different in many ways to other inks developed for other printing applications such as pigmented solid (or phase change) inks. Digital offset or DALI inks preferably contain much higher (in embodiments up to ten times higher) pigment loading and therefore have a higher viscosity at room temperature. High viscosity is desired for transfer, but must be low enough for anilox take-up and delivery to the fluorosilicone plate.

While currently available inks may be suitable for their intended purpose, there remains a need for improved DALI inks that enable good transfer from the imaged blanket to the receiving substrate such that the resultant prints are robust to solvent and have good adhesion to the substrate.

Described is an ink composition for use in digital offset printing, comprising at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C.

Also described is a process of digital offset printing, the process comprising applying an ink composition onto a re-imageable imaging member surface at an ink take up temperature, the re-imageable imaging member having dampening fluid disposed thereon; forming an ink image; transferring the ink image from the re-imageable surface of the imaging member to a printable substrate at an ink transfer temperature; wherein the ink composition comprises at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C.

Also described is a process comprising combining at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C; optionally, heating; and optionally, filtering; to provide an ink composition.
Figure 1 illustrates a schematic representation of a related art ink-based variable image digital printing system with which the ink compositions according to this disclosure may be used.
Figure 2 is a depiction of the rating system used in ASTM D3359, "Measuring Adhesion by Tape" test.

The use of miscible additives in DALI ink compositions is described to improve the printed ink robustness properties including solvent resistance and adhesion to the substrate. The additives by their nature are non-radiation curable, but, as components within the DALI ink compositions described, they do not interfere with the absorption of curing radiation nor the level of cure and physical robustness of the resultant prints prepared with these inks. In embodiments, the ink compositions exhibit enhanced robustness of prints prepared with the inks including solvent resistance and adhesion to the substrate on which they were printed.

It is highly desirable for DALI ink compositions to possess adequate, preferably outstanding, characteristics and performance including anilox filling from the ink loader, transfer to the blanket, and ultimate high transfer of the ink image from the blanket to the receiving substrate. The present ink compositions include ink additives providing inks which maintain viscosity and tack properties within a range required to achieve key print functions in DALI printing applications.

In embodiments, the ink has relatively low viscosity within a temperature range of, in embodiments, from about 45 to about 80 °C, such as from about 50 to about 70 °C, such as from about 55 to about 65 °C, such as about 60 °C, at shear rates corresponding to the equivalent angular frequencies from about 50 to about 200 rad/s such as about 100 rad/s. It is also highly advantageous to ensure a high degree of ink transfer from the anilox roller to the blanket such that the ink has relatively high viscosity within a temperature range of, in embodiments, from about 18 to about 35 °C, such as from about 18 to about 30 °C, such as about 25 °C, at shear rates corresponding to the equivalent angular frequencies from about 0.5 to about 2 rad/s such as about 1 rad/s.

In embodiments, the ink composition has a first viscosity of from about 3,000 to about 90,000 centipoise at an ink take up temperature of from about 45 °C to about 80 °C; and the ink composition has a second viscosity of from about 100,000 to about 2,000,000 centipoise at an ink transfer temperature of from about 18 °C to about 30 °C.

In embodiments, the ink composition has a first viscosity of from about 3,000 to about 90,000 centipoise at an ink take up temperature of from about 45 °C to about 80 °C and a relatively higher shear rate of from about 50 rad/s to about 200 rad/s; and the ink composition has a second viscosity of from about 100,000 to about 2,000,000 centipoise at an ink transfer temperature of from about 18 °C to about 30 °C and a relatively lower angular frequency of from about 0.5 rad/s to about 2 rad/s.

In certain embodiments, the ink compositions herein have a viscosity of from about 10,000 centipoise at a temperature of about 40 °C to about 800,000 centipoise at a temperature of about 20 °C.

The ink compositions herein include curable ink compositions containing one or more non-curable additives that are miscible and that enable the ink composition to function normally with respect to ink delivery and anilox filling, inking onto the blanket, and subsequent transfer to the receiving substrate. A resultant radiation cured print prepared with the non-curable additive has enhanced robustness under conditions used to test the robustness of the print. Unexpectedly, the addition of the present non-reactive additives to the present DALI curable ink compositions affords higher adhesion of printed and cured ink on the substrate compared to DALI curable inks without these additives.

In embodiments, the non-curable additives possess paraffinic character and comprise waxes or waxy resins. In embodiments, the non-curable additives are solid at room temperature, such as at a temperature of from about 20 °C to about 40 °C, or from about 20 °C to about 30 °C, or from about 20 °C to about 25 °C. The non-curable additives described herein enable a broad formulation range for DALI inks and enable DALI prints comprising room temperature solid based and non-radiation curable additives to be robust against the unwanted blooming, leaching, and other migration tendencies that can occur over time compared to additives which are liquid based at room temperature.

In embodiments, the non-curable, solid at room temperature additives herein have desired inherent properties including limited solvent solubility, good mar resistance, good slip and release properties, and are hard at and near room temperature. The non-curable additives herein impart robustness to radiation cured prints made from the inks. Such improvements in print robustness include those properties of adhesion, solvent resistance, mar resistance, and friction, for example. Not all additives impart the desired robustness properties, and which additives can be successfully used in DALI inks cannot be predicted. In embodiments, ink additives having paraffinic character further demonstrate decreasing the sensitivity of the DALI inks to oxygen inhibition. Without wishing to be bound by theory, it is believed that the additives act as barriers to air as the inks are printed and before they are cured by, for example, UV (ultra-violet) radiation. The lowered sensitivity to oxygen inhibition improves cure.

In embodiments, an ink composition for use in digital offset printing herein comprises at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C, or from about 20 °C to about 30 °C, or from about 20 °C to about 25 °C. In embodiments, an ink composition for use in digital offset printing herein consists of at least one component selected from the group consisting of a curable monomer and a curable oligomer; an optional dispersant; an optional photoinitiator; and at least one non-radiation curable additive, wherein the non-radiation curable additive is a solid at a temperature of from about 20 °C to about 40 °C, or from about 20 °C to about 30 °C, or from about 20 °C to about 25 °C. In embodiments, an ink composition for use in digital offset printing herein consists essentially of at least one component selected from the group consisting of a curable monomer and a curable oligomer; an optional dispersant; an optional photoinitiator; and at least one non-radiation curable additive, wherein the non-radiation curable additive is a solid at a temperature of from about 20 °C to about 40 °C, or from about 20 °C to about 30 °C, or from about 20 °C to about 25 °C.

### Additives.

The ink compositions herein include at least one additive comprising a non-curable additive that is a solid at or near room temperature. In embodiments, the non-radiation curable additive is a solid at a temperature of from about 20 °C to about 40 °C, or from about 20 °C to about 30 °C, or from about 20 °C to about 25 °C.

The ink compositions herein include additives from various chemical classes or groupings and molecular weight ranges. The additives include wax, ethoxylated long chain alcohol, hyper-branched olefin, long chain, fully saturated, linear primary alcohol, and higher ester wax chemical classes. Additive properties such as safety, melting point, or congealing point or glass transition temperature as well as the availability and cost of the additives were considered.

In embodiments, the non-curable additives herein are miscible or emulsifiable in water. In other embodiments, water insoluble non-curable additives herein include those that are olefin or largely hydrocarbon based, but that can act as releasing agents which improve transfer of an ink image from a fluorosilicone blanket to a receiving substrate such as coated paper. The olefin or largely hydrocarbon based additives offer improved barrier resistance of a film or radiation cured print which can improve the solvent/chemical resistance of the print and also impart scratch resistant properties. In embodiments, hydrocarbon based olefins comprise cyclic and acyclic alkenes as well as dienes and polyenes.

In embodiments, the non-radiation curable additives herein do not adversely affect key DALI ink properties such as pigment dispersion quality, clay dispersion quality, rheology of an ink at 25 °C, 45 °C, and the like, or the tack (internal cohesion) of an ink. In embodiments, the non-radiation curable additives herein impart desirable characteristics such as lubricating quality to DALI inks.

The non-curable additives herein can have different chemical structures, molecular weights, and other properties, as long as the additives meet the criteria of being non-curable, solid at room temperature, and impart one or more of the desired characteristics to the DALI ink as described herein.

By non-curable it is meant that the additive in the ink is not cross-linkable by such means as from exposure to, for example, heat, electromagnetic radiation, electron beam energies, and the like.

Table 1 provides a list of some exemplary non-curative additives that can be selected for embodiments herein. The additives in Table 1 include components with a range in polarities, melting points, molecular weights, etc. The additives in Table 1 have varying degrees of paraffinic character.

Molecular weight as used herein means weight average molecular weight as measured by gel permeation chromatography and using polystyrene as standard for calibration.

In embodiments, the at least one non-radiation curable additive is selected from the group consisting of wax, hyper-branched wax, carnauba wax, beeswax, higher molecular weight ester wax having a molecular weight of from about 300 to about 900, hydrocarbon based olefin, waxy resin, paraffin, long chain ether having from about 20 to about 60 carbon atoms, or from about 28 to about 60 carbon atoms, ethoxylated long chain alcohol having from about 24 to about 44 carbon atoms, long chain fully saturated primary alcohol having from about 20 to about 60 carbon atoms, or from about 28 to about 60 carbon atoms or from about 20 to about 40 carbon atoms, and combinations thereof. In embodiments, the at least one non-radiation curable additive is selected from the group consisting of carnauba wax, beeswax, higher molecular weight ester wax having a molecular weight of from about 300 to about 900, hydrocarbon based olefin, long chain ether having from about 20 to about 60 carbon atoms, ethoxylated long chain alcohol having from about 24 to about 44 carbon atoms, long chain fully saturated primary alcohol, having from about 20 to about 60 carbon atoms, and combinations thereof.

In embodiments, the at least one non-radiation curable additive is a polyolefin having a molecular number (Mn) range of from about 1500 to about 5000 g/mol.

In certain embodiments, the at least one non-radiation curable additive is selected from the group consisting of long chain fully saturated primary alcohol, having from about 28 to about 60 carbon atoms, long chain ether having from about 28 to about 60 carbon atoms, and combinations thereof.

In embodiments, a non-curable additive herein comprises an additive having an n-paraffin hydrocarbon number in the range of from about 24 to about 28. In other embodiments, a non-curable additive herein comprises an additive having an n-paraffin hydrocarbon number of 28 or higher. In embodiments, a non-curable additive herein comprises an additive having an n-paraffin hydrocarbon number of from about 28 to about 60. In embodiments, the non-radiation curable additive comprises a paraffin having from about 24 to about 28 carbon atoms. In embodiments, the non-radiation curable additive comprises a paraffin having greater than about 28 carbon atoms, in embodiments, from greater than about 28 to about 60 carbon atoms.

In embodiments, the non-curable additive herein comprises a paraffin hydrocarbon or alkane having at least about 15 carbon atoms, or from about 15 to about 50 carbon atoms, or from about 24 to about 50 carbon atoms, or from about 28 to about 60 carbon atoms. In embodiments, the non-curable additive herein comprises a straight chain paraffin hydrocarbon or alkane having at least about 15 carbon atoms, or from about 15 to about 50 carbon atoms, or from about 24 to about 50 carbon atoms, or from about 28 to about 60 carbon atoms.

In embodiments, a non-curable additive herein comprises carnauba wax. Carnauba wax comprises long chain alkyl esters of wax acids, free wax acids, lactides, free and combined polyhydric and oxy-alcohols, alcohol-soluble resins, and hydrocarbons, as well as other constituents in relatively small amounts

In embodiments, a non-curable additive herein comprises beeswax. Beeswax, before refining, primarily comprises esters of wax acids as well as free long chain alcohols, free long chain wax acids, and hydrocarbons, as well as other constituents in relatively small amounts.

As used herein, in embodiments, long chain means from about 18 to about 60, or from about 22 to about 52, or from about 25 to about 46 carbon atoms.

Vybar™ grades of materials, available from Baker Hughes, are hyper-branched aliphatic polymers with varying molecular weights and degrees of branching. By hyper-branched it is meant that the polymer is a highly branched macromolecule and can have imperfect or perfect branching, the latter that describes dendrimers.

In embodiments, the at least one non-radiation curable additive comprises a wax having a melting point of less than about 100 °C. In embodiments, the at least one non-radiation curable additive comprises a hyper-branched wax having a melting point of less than about 100 °C.

Unithox™ grades of materials, available from Baker Hughes, are ethoxylated analogs of fully saturated, long chain, linear, C20 to C50 Unilin™ alcohols. The Unilin™ alcohol series includes Unilin™ 350 alcohol, Unilin™ 425 alcohol, Unilin™ 550 alcohol, and Unilin™ 700 alcohol. For further detail, see http://www.bakerhughes.com/news-and-media/resources/technical-data-sheet/unilin-alcohols. The properties of Unithox™ materials, including hardness and melting point, depend on the type and amounts of Unilin™ alcohol and ethylene oxide used to make them.

In embodiments, the non-radiation curable additive comprises poly(maleic anhydride-alt-olefin C24-C28).

**Table 1**

| **Additive** | **Component** | **Vendor** | **Mw** |
|---|---|---|---|
| A1 | Poly(maleic anhydride-alt-olefin C24-C28) | Sigma-Aldrich | 6400 |
| A2 | Carnauba wax | Koster-Keunen | n/a |
| A3 | Beeswax, bleached white | Sigma-Aldrich | n/a |
| A4 | Vybar™ 343 | Baker Hughes | n/a |
| A5 | Vybar™ 260 | Baker Hughes | n/a |
| A6 | Unithox™ 490 | Baker Hughes | 4600 |
| A7 | Unithox™ 480 | Baker Hughes | 2300 |
| A8 | Unithox™ 350 | Baker Hughes | n/a |

In embodiments, the ink compositions include a pigment and a clay. Due to the complex nature of the pigment-clay component interactions in certain DALI inks, it is not obvious how soluble, miscible, or compatible a given additive will be with the DALI ink formulation until it is tested. Some additives that possess limited or non-solubility in a DALI ink base at room temperature could interact compatibly with the pigment and clay found in certain DALI CMYK (cyan, magenta, yellow, black) inks and is proposed to be the case of additive A1 in Table 2.

**Table 2**

| Additive | Component | Vendor | **Solubility in DALI Ink Base at** | | |
|---|---|---|---|---|---|
| | | | 85 °C | R.T. after 2 hours | R.T. after 18 hours |
| A1 | Poly(maleic anhydride-alt-olefin C24-C28) | Sigma-Aldrich | Yes. | Yes, slight haze. | No, more haze. |
| A2 | Carnauba wax | Koster-Keunen | Yes. | Yes. | Yes. |
| A3 | Beeswax, bleached white | Sigma-Aldrich | Yes. | Yes. | Yes. |
| A4 | Vybar™ 343 | Baker Hughes | Yes. | Yes. | Yes. |
| A5 | Vybar™ 260 | Baker Hughes | Yes. | Yes. | Yes. |
| A6 | Unithox™ 490 | Baker Hughes | Yes. | Yes. | Yes. |
| A7 | Unithox™ 480 | Baker Hughes | Yes. | Yes. | Yes. |
| A8 | Unithox™ 350 | Baker Hughes | Yes. | Yes. | Yes. |

In Table 2, R.T. is room temperature of from about 20 to about 25 °C.

The non-radiation curable additive can be present in the ink composition in any suitable or desired amount. In embodiments, the non-radiation curable additive is present in the ink composition in an amount of from about 1 to about 6 percent by weight based upon the total weight of the ink composition. In embodiments, the non-radiation curable additive is present in the ink composition in an amount of from about 1 to less than about 5 percent by weight based upon the total weight of the ink composition.

### Monomers, Oligomers.

In embodiments, the ink composition of the present disclosure includes further components such as a suitable curable monomer. Examples of suitable materials include radically curable monomer compounds, such as acrylate and methacrylate monomer compounds. Specific examples of acrylate and methacrylate monomers include (but are not limited to) isobornyl acrylate, isobornyl methacrylate, lauryl acrylate, lauryl methacrylate, isodecylacrylate, isodecylmethacrylate, caprolactone acrylate, 2-phenoxyethyl acrylate, isooctylacrylate, isooctylmethacrylate, butyl acrylate, alkoxylated lauryl acrylate, ethoxylated nonyl phenol acrylate, ethoxylated nonyl phenol methacrylate, ethoxylated hydroxyethyl methacrylate, methoxy polyethylene glycol monoacrylate, methoxy polyethylene glycol monomethacrylate, tetrahydrofurfuryl methacrylate, tetrahydrofurfuryl methacrylate and the like, as well as mixtures or combinations thereof.

In embodiments, the at least one component selected from the group consisting of a curable monomer and a curable oligomer in the ink composition herein is a component selected from the group consisting of acrylated polyesters, acrylated polyethers, acrylated epoxies, urethane acrylates, and pentaerythritol tetraacrylate, and combinations thereof.

In specific embodiments, propoxylated trimethylolpropane triacrylate such as SR501 from Sartomer Co. is used. The monomers may be present in the ink composition of the present disclosure in any suitable or desired amount, in embodiments in an amount of from about 0% to about 50% by weight, such as about 1% to about 30% by weight, such as about 5% to about 30% by weight, such as about 5% to about 10% by weight, based upon the total weight of the ink composition.

In some embodiments, the ink composition of the present disclosure includes a curable oligomer. Suitable curable oligomers include, but are not limited to acrylated polyesters, acrylated polyethers, acrylated epoxies, urethane acrylates, and pentaerythritol tetraacrylate. Specific examples of suitable acrylated oligomers include, but are not limited to, acrylated polyester oligomers, such as CN2255®, CN2256®, CN294E®, CN2282® (Sartomer Co.), and the like, acrylated urethane oligomers, acrylated epoxy oligomers, such as CN2204®, CN110® (Sartomer Co.) and the like; and mixtures and combinations thereof. In embodiments, the at least one component selected from the group consisting of a curable monomer and a curable oligomer in the ink composition herein is a component selected from the group consisting of a tetrafunctional polyester acrylate oligomer, a propoxylated trimethylolpropane triacrylate monomer, and combinations thereof. The oligomers may be present in the ink composition in any suitable or desired amount, in embodiments in an amount of about 0% to about 50% by weight, such as about 1% to about 30% by weight, such as about 5% to about 30% by weight, based upon the total weight of the ink composition.

In certain embodiments, the inks described herein may include the following components: (a) radiation-curable water-dilutable monomer compounds, including mono-, di-, and tri-functional water-dilutable acrylate monomers, oligomers; (b) dispersants; (c) colorant; (d) clays or other additives; (e) initiators; (f) additional curable compounds including monomers, oligomers, including oligomers from Sartomer USA, LLC or Cytec Industries, Inc., prepolymers, polymers; (g) at least one non-radiation curable additive as described herein; (h) secondary additives including surfactants, free-radical scavengers, and the like; and (i) thermal stabilizers.

In embodiments, the water-diluted curable components may include any water-dilutable acrylate or methacrylate monomer compound(s) suitable for use as a vehicle that may be water dilutable, with an addition of water being available to adjust and/or enhance background performance for use in the variable digital data lithographic printing architecture. In embodiments, the water-diluted curable component is a water-dilutable functional acrylate monomer, a methacrylate monomer, a multifunctional acrylate monomer, a multifunctional methacrylate monomer, or a mixture or combination thereof. Exemplary acrylates may include acrylate monomers or polymers such as polyester acrylates Sartomer CN294E, Sartomer CD-501, Sartomer CN9014, Sartomer CN2282 and Sartomer CN2256. In embodiments, a mixture of the components is water-dilutable.

In embodiments, further examples of curable monomers and diluting acrylates which can be used in the ink compositions as vehicles may include trimethylolpropane triacrylate; SR-492, SR-501, SR-444, SR-454, SR-499, SR-502, SR-9035 and SR-415 from Sartomer; EBECRYL® 853 and EBECRYL® 5500 from Allnex. Trimethylolpropane triacrylate has a refractive index of 1.474, a specific gravity of 1.06 g/cm³, an APHA Color of less than 300 and a viscosity range of 80 to 120 cps at 25°C. Sartomer SR-492 is a three mole propoxylated trimethylolpropane triacrylate and has a refractive index of 1.459, a specific gravity of 1.05 g/cm³, a Tg of -15°C, an APHA Color of 30 and a viscosity of 90 cps at 25°C. Sartomer SR-501 is a six mole propoxylated trimethylolpropane triacrylate and has a refractive index of 1.4567, a specific gravity of 1.048 g/cm³, a Tg of -2°C, an APHA Color of 90 and a viscosity of 125 cps at 25°C. Sartomer SR-444 is a pentaerythritol triacrylate and has a refractive index of 1.4801, a specific gravity of 1.162 g/cm³, a Tg of 103°C, an APHA Color of 50 and a viscosity of 520 cps at 25°C. Sartomer SR-454 is a three mole ethoxylated trimethylolpropane triacrylate and has a refractive index of 1.4689, a specific gravity of 1.103 g/cm³, a Tg of 120°C, an APHA Color of 55 and a viscosity of 60 cps at 25°C. Sartomer SR-499 is a six mole ethoxylated trimethylolpropane triacrylate and has a refractive index of 1.4691, a specific gravity of 1.106 g/cm³, a Tg of -8°C, an APHA Color of 50 and a viscosity of 85 cps at 25°C. Sartomer SR-502 is a nine mole ethoxylated trimethylolpropane triacrylate and has a refractive index of 1.4691, a specific gravity of 1.11 g/cm³, a Tg of -19°C, an APHA Color of 140 and a viscosity of 130 cps at 25°C. Sartomer SR-9035 is a fifteen mole ethoxylated trimethylolpropane triacrylate and has a refractive index of 1.4695, a specific gravity of 1.113 g/cm3, a Tg of -32°C, an APHA Color of 60 and a viscosity of 168 cps at 25°C. Sartomer SR-415 is a twenty mole ethoxylated trimethylolpropane triacrylate and has a refractive index of 1.4699, a specific gravity of 1.115 g/cm3, a Tg of -40°C, an APHA Color of 55 and a viscosity of 225 cps at 25°C. EBECRYL® 853 is a low viscosity polyester triacrylate and has a specific gravity of 1.10 g/cm3, an APHA Color of 200 and a viscosity of 80 cps at 25°C. EBECRYL® 5500 is a low viscosity glycerol derivative triacrylate and has a specific gravity of 1.07 g/cm³, an APHA Color of 62 and a viscosity of 130 cps at 25°C. Other triacrylate, monoacrylate, diacrylate, tetraacrylate and higher functional acrylate monomers, diluting acrylates, and various combinations thereof, can also be used in the ink compositions as vehicles.

In embodiments, one or more components in a mixture may be non-water dilutable, if the ink is water dilutable, and the reactive component are themselves miscible. In the same way that water may be added, in some embodiments, co-reactive monomers may be added to control polarity of the ink. Specific examples of water-dilutable curable components include, but are not limited to, the functional water soluble aromatic urethane acrylate compound (available from CYTEC as EBECRYL® 2003), the di-functional compound polyethylene glycol diacrylate (available from CYTEC as EBECRYL® 11), and the tri-functional compound polyether triacrylate (available from CYTEC as EBECRYL® 12). The monomer or oligomer can be present in any suitable amount. In embodiments, the monomer or oligomer, or combination thereof is added in an amount of from about 10 to about 85%, or from about 30 to about 80%, or from about 50 to about 70%, by weight based on the total weight of the curable ink composition. Curable oligomers which can be used in the ink compositions as vehicles may include Sartomer CN294E; CN2256; CN2282; CN9014 and CN309. Sartomer CN294E is a tetrafunctional acrylated polyester oligomer. CN294E is a clear liquid having a specific gravity of 0.93 and a viscosity of 4,000 cps at 60°C. Sartomer CN2256 is a difunctional polyester acrylate oligomer and has a refractive index of 1.5062, a Tg of -22°C, a tensile strength of 675 psi, and a viscosity of 11,000 cps at 60°C.

Sartomer CN2282 is tetrafunctional acrylated polyester and is a clear liquid having a specific gravity of 1.15 and a viscosity of 2,500 cps at 60°C. Sartomer CN9014 is a difunctional acrylated urethane and is a non-clear liquid having a specific gravity of 0.93 and a viscosity of 19,000 cps at 60°C. Sartomer CN309 is an oligomer containing an acrylate ester that derives from an aliphatic hydrophobic backbone, or in other words is an aliphatic acrylate ester. CN309 is a clear liquid having a specific gravity of 0.92, a density of 7.68 pounds/gallon, a surface tension of 26.3 dynes/cm, a viscosity of 150 cps at 25°C, and a viscosity of 40 cps at 60°C.

Examples of curable oligomers which can be used in the ink compositions as vehicles may include CN294E, CN2256, CN2282, CN9014 and CN309 from Sartomer; EBECRYL® 8405, EBECRYL® 8411, EBECRYL® 8413, EBECRYL® 8465, EBECRYL® 8701, EBECRYL® 9260, EBECRYL® 546, EBECRYL® 657, EBECRYL® 809, and the like from Allnex. EBECRYL® 8405 is a tetrafunctional urethane acrylate diluted as 80 wt% by weight in 1,6-Hexanediol diacrylate (HDDA). EBECRYL® 8405 is a clear liquid having a Gardner Color of 2 and a viscosity of 4,000 cps at 60°C. EBECRYL® 8411 is a difunctional urethane acrylate diluted as 80 wt% by weight in isobornylacrylate (IBOA). EBECRYL® 8411 is a clear liquid having a viscosity range of 3,400 to 9,500 cps at 65°C. EBECRYL® 8413 is a difunctional urethane acrylate diluted as 67 wt% by weight in IBOA. EBECRYL® 8413 is a clear liquid having a viscosity of 35,000 cps at 60°C. EBECRYL® 8465 is a trifunctional urethane acrylate. EBECRYL® 8465 is a clear liquid having a Gardner Color of 2 and a viscosity of 21,000 cps at 60°C. EBECRYL® 8701 is a trifunctional urethane acrylate. EBECRYL® 8701 is a clear liquid having a Gardner Color of 2 and a viscosity of 4,500 cps at 60°C. EBECRYL® 9260 is a trifunctional urethane acrylate. EBECRYL® 9260 is a clear liquid having a Gardner Color of 2 and a viscosity of 4,000 cps at 60°C. EBECRYL® 546 is a trifunctional polyester acrylate. EBECRYL® 546 is a clear liquid having a Gardner Color of 1.5 and a viscosity of 350,000 cps at 25°C. EBECRYL® 657 is a tetrafunctional polyester acrylate. EBECRYL® 657 is a clear liquid having a Gardner Color of 4 and a viscosity of 125,000 cps at 25°C. EBECRYL® 809 is a trifunctional polyester acrylate. EBECRYL® 809 is a clear liquid having a Gardner Color of 3 and a viscosity of 1,300 cps at 60°C.

### Photoinitiator.

In some embodiments, the ink composition includes a photoinitiator, such as a α-hydroxyketone photo-initiator (including α-hydroxyketone photoinitators sold under the trade name IRGACURE® 184, IRGACURE® 500, DAROCUR® 1173, and IRGACURE® 2959, which are manufactured by BASF), α-aminoketone photo-initiators (including α-aminoketone photo-initiators IRGACURE® 369, IRGACURE® 379, IRGACURE® 907, and IRGACURE® 1300, which are manufactured by BASF) and bisacyl phosphine photo-initiators (including bisacyl phospine photo-initiators sold under the trade name IRGACURE® 819, IRGACURE® 819DW, and IRGACURE® 2022, which are manufactured by BASF). Other suitable photo-initiators include monoacylphosphine oxide and bisacylphosphine oxide, such as 2,4,6-trimethylbenzoybiphenylphosphine oxide (manufactured by BASF under the trade name LUCIRIN® TPO); ethyl-2,4,6-trimethylbenzoylphenyl phosphinate (manufactured by BASF under the trade name LUCIRIN® TPO-L); mono- and bis-acylphosphine photoinitiators (such IRGACURE® 1700, IRGACURE® 1800, IRGACURE® 1850, and DAROCUR® 4265, manufactured by BASF), benzyldimethyl-ketal photo-initiators (such as IRGACURE® 651, manufactured by BASF) and oligo[2-hydroxy-2-methyl-1-[4-(1-methylvinyl)phenyl]propanone] (available as Esacure® KIP 150 from Lamberti); and the like, as well as mixtures thereof.

The photoinitiator or mixture of photoinitiators may be present in the ink composition of the instant disclosure in any suitable or desired amount, in embodiments, in an amount of about 0% to about 12% by weight, such as about 1% to about 10%, by weight such as about 2% to about 8% by weight, based upon the total weight of the ink composition.

In some embodiments, the ink composition of the present disclosure comprises a free radical scavenger, such as IRGASTAB® UV10, IRGASTAB® UV22 available from BASF or CN3216 available from Sartomer Co. The free radical scavenger may be present in the ink composition in any suitable or desired amount, in embodiments in an amount of about 0% to about 5% by weight, such as from about 0.5% to about 4% by weight, such as about 2% to about 3% by weight, based upon the total weight of the ink composition.

### Filler.

In some embodiments, the ink composition of the present disclosure includes a filler or fillers. Suitable fillers may include, but are not limited to, amorphous, diatomaceous, fumed quartz and crystalline silica, clays, aluminum silicates, magnesium aluminum silicates, talc, mica, delaminated clays, calcium carbonates and silicates, gypsum, barium sulfate, zinc, calcium zinc molybdates, zinc oxide, phosphosilicates and borosilicates of calcium, barium and strontium, barium metaborate monohydrate, and the like. In specific embodiments, the filler may be clays from Southern Clay Products CLAYTONE® HA and CLAYTONE® HY. In some embodiments, filler may be present in the ink composition of the present disclosure in an amount from about 0% to about 50% by weight, such as about 1% to about 20% by weight, such as from about 2% to about 10% by weight, based upon the total weight of the ink composition.

### Colorant.

The ink composition herein may also contain a colorant. Any suitable or desired colorant can be used in embodiments herein, including pigments, dyes, dye dispersions, pigments dispersions, and mixtures and combinations thereof.

The colorant may include any suitable or desired color including cyan, magenta, yellow, black, and combinations thereof. The robustness properties of the ink compositions herein are achieved with the additives described for any color or combination selected, including cyan, magenta, yellow, black, and combinations thereof. In embodiments, the colorant comprises a pigment. In further embodiments, the colorant is provided in the form of a pigment dispersion. In certain embodiments, the ink compositions contain a pigment, in embodiments provided in the form of a pigment dispersion, and a clay.

The colorant may be provided in the form of a colorant dispersion. In embodiments, the colorant dispersion has an average particle size of from about 20 to about 500 nanometers (nm), or from about 20 to about 400 nm, or from about 30 to about 300 nm. In embodiments, the colorant is selected from the group consisting of dyes, pigments, and combinations thereof, and optionally, the colorant is a dispersion comprising a colorant, an optional surfactant, and an optional dispersant.

As noted, any suitable or desired colorant can be selected in embodiments herein. The colorant can be a dye, a pigment, or a mixture thereof. Examples of suitable dyes include anionic dyes, cationic dyes, nonionic dyes, zwitterionic dyes, and the like. Specific examples of suitable dyes include Food dyes such as Food Black No. 1, Food Black No.2, Food Red No. 40, Food Blue No.1, Food Yellow No.7, and the like, FD & C dyes, Acid Black dyes (No.1, 7, 9, 24, 26, 48, 52, 58, 60, 61, 63, 92, 107, 109, 118, 119, 131, 140, 155, 156, 172, 194, and the like), Acid Red dyes (No. 1, 8, 32, 35, 37, 52, 57, 92, 115, 119, 154, 249, 254, 256, and the like), Acid Blue dyes (No. 1, 7, 9, 25, 40, 45, 62, 78, 80, 92, 102, 104, 113, 117, 127, 158, 175, 183, 193,209, and the like), Acid Yellow dyes (No.3, 7, 17, 19, 23, 25, 29, 38, 42, 49, 59, 61, 72, 73, 114, 128, 151, and the like), Direct Black dyes (No.4, 14, 17, 22, 27, 38, 51,112,117,154,168, and the like), Direct Blue dyes (No. 1, 6,8, 14, 15,25, 71, 76, 78, 80,86,90, 106,108,123,163,165, 199,226,and the like), Direct Red dyes (No. 1, 2, 16, 23, 24, 28, 39, 62, 72, 236, and the like), Direct Yellow dyes (No.4, 11, 12, 27, 28, 33, 34, 39, 50, 58, 86, 100, 106, 107, 118, 127, 132, 142, 157, and the like), Reactive Dyes, such as Reactive Red Dyes (No.4, 31, 56, 180, and the like), Reactive Black dyes (No. 31 and the like), Reactive Yellow dyes (No. 37 and the like); anthraquinone dyes, monoazo dyes, disazo dyes, phthalocyanine derivatives, including various phthalocyanine sulfonate salts, aza(18)annulenes, formazan copper complexes, triphenodioxazines, and the like; as well as mixtures thereof.

Examples of suitable pigments include black pigments, white pigments, cyan pigments, magenta pigments, yellow pigments, and the like. Further, pigments can be organic or inorganic particles. Suitable inorganic pigments include carbon black. However, other inorganic pigments may be suitable such as titanium oxide, cobalt blue (CoO-Al₂0₃), chrome yellow (PbCr0₄), and iron oxide. Suitable organic pigments include, for example, azo pigments including diazo pigments and monoazo pigments, polycyclic pigments (e.g., phthalocyanine pigments such as phthalocyanine blues and phthalocyanine greens), perylene pigments, perinone pigments, anthraquinone pigments, quinacridone pigments, dioxazine pigments, thioindigo pigments, isoindolinone pigments, pyranthrone pigments, and quinophthalone pigments), insoluble dye chelates (e.g., basic dye type chelates and acidic dye type chelate), nitro pigments, nitroso pigments, anthanthrone pigments such as PR168, and the like. Representative examples of phthalocyanine blues and greens include copper phthalocyanine blue, copper phthalocyanine green, and derivatives thereof (Pigment Blue 15, Pigment Green 7, and Pigment Green 36). Representative examples of quinacridones include Pigment Orange 48, Pigment Orange 49, Pigment Red 122, Pigment Red 192, Pigment Red 202, Pigment Red 206, Pigment Red 207, Pigment Red 209, Pigment Violet 19, and Pigment Violet 42. Representative examples of anthraquinones include Pigment Red 43, Pigment Red 194, Pigment Red 177, Pigment Red 216 and Pigment Red 226. Representative examples of perylenes include Pigment Red 123, Pigment Red 149, Pigment Red 179, Pigment Red 190, Pigment Red 189 and Pigment Red 224. Representative examples of thioindigoids include Pigment Red 86, Pigment Red 87, Pigment Red 88, Pigment Red 181, Pigment Red 198, Pigment Violet 36, and Pigment Violet 38. Representative examples of heterocyclic yellows include Pigment Yellow 1, Pigment Yellow 3, Pigment Yellow 12, Pigment Yellow 13, Pigment Yellow 14, Pigment Yellow 17, Pigment Yellow 65, Pigment Yellow 73, Pigment Yellow 74, Pigment Yellow 90, Pigment Yellow 110, Pigment Yellow 117, Pigment Yellow 120, Pigment Yellow 128, Pigment Yellow 138, Pigment Yellow 150, Pigment Yellow 151, Pigment Yellow 155, and Pigment Yellow 213. Such pigments are commercially available in either powder or press cake form from a number of sources including, BASF Corporation, Engelhard Corporation, and Sun Chemical Corporation. Examples of black pigments that may be used include carbon pigments. The carbon pigment can be almost any commercially available carbon pigment that provides acceptable optical density and print characteristics. Carbon pigments suitable for use in the present system and method include, without limitation, carbon black, graphite, vitreous carbon, charcoal, and combinations thereof. Such carbon pigments can be manufactured by a variety of known methods, such as a channel method, a contact method, a furnace method, an acetylene method, or a thermal method, and are commercially available from such vendors as Cabot Corporation, Columbian Chemicals Company, Evonik, and E.I. DuPont de Nemours and Company. Suitable carbon black pigments include, without limitation, Cabot pigments such as MONARCH®® 1400, MONARCH® 1300, MONARCH® 1100, MONARCH® 1000, MONARCH® 900, MONARCH® 880, MONARCH® 800, MONARCH® 700, CAB-O-JET® 200, CAB-O-JET 300, REGAL, BLACK PEARLS®, ELFTEX®, MOGUL®, and VULCAN® pigments; Columbian pigments such as RAVEN® 5000, and RAVEN® 3500; Evonik pigments such as Color Black FW 200, FW 2, FW 2V, FW 1, FW18, FW S160, FW S170, Special Black 6, Special Black 5, Special Black 4A, Special Black 4, PRINTEX® U, PRINTEX® 140U, PRINTEX® V, and PRINTEX® 140V. The above list of pigments includes unmodified pigment particulates, small molecule attached pigment particulates, and polymer-dispersed pigment particulates. Other pigments can also be selected, as well as mixtures thereof. The pigment particle size is desired to be as small as possible to enable a stable colloidal suspension of the particles in the liquid vehicle and to prevent clogging of the ink channels when the ink is used in a thermal ink jet printer or a piezoelectric ink jet printer. In embodiments, the colorant is a magenta colorant. In embodiments, the colorant is a magenta pigment.

The colorant can be present in the ink composition in any desired or effective amount, in embodiments, the colorant can be present in an amount of from about 0.05 to about 15 percent, or from about 0.1 to about 10 percent, or from about 1 to about 5 percent by weight, based on the total weight of the ink composition.

In embodiments, the ink composition herein further enables use of a high colorant concentration, in embodiments a colorant or pigment concentration of greater than 50 percent, in embodiments, greater than 60 percent, by weight based on the total weight of the ink composition, while maintaining desired characteristics of desired viscosity at room temperature and desired viscosity at heated temperature for ink transfer.

### Dispersant.

In some embodiments, the colorant is dispersed in a suitable dispersant. In embodiments, suitable dispersants include copolymers and block copolymers containing pigment affinic groups, such as amines, esters, alcohols and carboxylic acids and salts thereof. Illustrative examples of suitable dispersants include dispersants selected from Efka® 4008, Efka® 4009, Efka® 4047, Efka® 4520, Efka® 4010, Efka® 4015, Efka® 4020, Efka® 4050, Efka® 4055, Efka® 4080, Efka® 4300, Efka® 4330, Efka® 4400, Efka® 4401, Efka® 4403, Efka® 4406, Efka® 4800, all available from BASF, Charlotte, North Carolina., Disperbyk® 101, Disperbyk® 102, Disperbyk® 107, Disperbyk® 108, Disperbyk® 109, Disperbyk® 110, Disperbyk® 111, Disperbyk® 112, Disperbyk® 115, Disperbyk® 162, Disperbyk® 163, Disperbyk® 164, Disperbyk® 2001, all available from BYK Additives & Instruments, Wesel Germany, Solsperse® 24000 SC/GR, Solsperse® 26000, Solsperse® 32000, Solsperse® 36000, Solsperse® 39000, Solsperse® 41000, Solsperse® 71000 all available from Lubrizol Advanced Materials, Inc. Cleveland, Ohio or mixtures or combinations thereof.

In specific embodiments, the dispersant includes K-Sperse® XDA-504 from King Industries, Norfolk, Connecticut. The dispersant may be present in the ink composition of the instant disclosure in an amount of about 0% to about 30 % by weight, or from about 0% to about 20% by weight, or from about 1% to about 10% by weight, or from about 6% to about 10% by weight, based upon the total weight of the white ink composition.

In certain embodiments, the colorant and the dispersant together are present in the ink composition in an amount of from about 50 percent to about 85 percent by weight based on the total weight of the ink composition.

The ink compositions can be prepared by any suitable process, such as by simple mixing of the ingredients. One process entails mixing all of the ink ingredients together and filtering the mixture to obtain an ink. Inks can be prepared by mixing the ingredients, heating if desired, and filtering, followed by adding any desired additional additives to the mixture and mixing at room temperature with moderate shaking until a homogeneous mixture is obtained, in embodiments from about 5 to about 10 minutes. Alternatively, the optional ink additives can be mixed with the other ink ingredients during the ink preparation process, which takes place according to any desired procedure, such as by mixing all the ingredients, heating if desired, and filtering.

In embodiments, a process herein comprises combining at least one component selected from the group consisting of a curable monomer and a curable oligomer; an optional dispersant; an optional photoinitiator; and at least one non-radiation curable additive, wherein the non-radiation curable additive is a solid at a temperature of from about 20 °C to about 40 °C; optionally, heating; and optionally, filtering; to provide an ink composition.

The present disclosure further provides a method of digital offset printing, which includes applying the white ink composition of the present disclosure onto a re-imageable imaging member surface, the re-imageable imaging member having dampening fluid disposed thereon; forming an ink image; and transferring the ink image from the re-imageable surface of the imaging member to a printable substrate.

An exemplary digital offset printing architecture is shown in FIG. 1 described above. In embodiments, the ink compositions herein can be employed in a device such as the one described in FIG. 1.

In embodiments, a process of digital offset printing herein comprises applying an ink composition onto a re-imageable imaging member surface at an ink take up temperature, the re-imageable imaging member having dampening fluid disposed thereon; forming an ink image; transferring the ink image from the re-imageable surface of the imaging member to a printable substrate at an ink transfer temperature; wherein the ink composition comprises at least one component selected from the group consisting of a curable monomer and a curable oligomer; an optional dispersant; an optional photoinitiator; and at least one non-radiation curable additive, wherein the non-radiation curable additive is a solid at a temperature of from about 20 °C to about 40 °C. In embodiments, applying the ink composition comprises applying the ink composition using an anilox delivery system.

Curing of the ink can be effected by exposure of the ink image to actinic radiation at any desired or effective wavelength, in embodiments from about 200 nanometers to about 480 nanometers, although the wavelength can be outside of this range. Exposure to actinic radiation can be for any desired or effective period of time, in embodiments for about 0.2 second to about 30 seconds, or from about 1 second to 15 seconds, although the exposure period can be outside of these ranges. By curing is meant that the curable compounds in the ink undergo an increase in molecular weight upon exposure to actinic radiation, such as (but not limited to) crosslinking, chain lengthening, or the like.

The printed substrate can be cured by exposure to radiation, in embodiments ultraviolet radiation, at any point in the fabrication process resulting in robust prints.

Any suitable substrate, recording sheet, or removable support, stage, platform, and the like, can be employed for depositing the ink compositions herein, including plain papers such as XEROX® 4024 papers, XEROX® Image Series papers, Courtland 4024 DP paper, ruled notebook paper, bond paper, silica coated papers such as Sharp Company silica coated paper, JuJo paper, HAMMERMILL LASERPRINT® paper, and the like, glossy coated papers such as XEROX® Digital Color Gloss, Sappi Warren Papers LUSTROGLOSS®, and the like, transparency materials, fabrics, textile products, plastics, polymeric films, glass, glass plate, inorganic substrates such as metals and wood, as well as meltable or dissolvable substrates, such as waxes or salts, in the case of removable supports for free standing objects, and the like. In certain embodiments, the substrate is selected from the group consisting of paper, plastic, folded paperboard, Kraft paper, and metal.

The following Examples are being submitted to further define various species of the present disclosure. These Examples are intended to be illustrative only and are not intended to limit the scope of the present disclosure. Also, parts and percentages are by weight unless otherwise indicated.

A first comparative example pigmented ink without additive was formulated in such a way as to accommodate the addition of an additive. The following examples illustrate the additives and ink preparation processes used but do not serve to limit the kind of additives, levels of additives, and processes used in the present disclosure. Table 3 provides the components and weight percent for the ink formulation examples and comparative examples.

### Comparative Example 1

Preparation of concentrate (without additive). Based on a 1500 gram total scare of preparation of the ink, the first set of ink base components (including the dispersant, monomer, oligomer, and thermal stabilizer) were added in a 1 Liter stainless steel vessel. The vessel was placed on a heating mantle, available from IKA®, equipped with a thermocouple and stirrer apparatus also available from IKA®, and with an anchor impeller. The components in the vessel were stirred at about 200 RPM (revolutions per minute) for about 30 minutes at about 80 °C. Then, the second set of ink base components (the photoinitiators) were added slowly with stirring at about 80 °C which continued for about another hour. With the vehicle base components solubilized, the given quantity of colored pigment was added to the system where more vigorous stirring occurred but not to the point where air was being entrained into the system. The pigmented mixture was allowed to stir for about 30 minutes at about 400 RPM at which point the clay was added slowly to the pigmented mixture at reduced RPM but then re-stirred for about another 15 minutes at about 400 RPM. The vessel containing the mixed components was transferred to a high speed shearing mill, available from the Hockmeyer Equipment Corporation, equipped with a 40 mm diameter high shear Cowles blade which was then stirred at 5300 RPM for about an hour. The thoroughly mixed component mixture was then discharged into glass jars.

### Example 2

Preparation of Ink with Carnauba Wax. The ink of Comparative Example 1 was diluted with Additive A2 such as to realize the composition shown in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 3

Preparation of Ink with Bleached White Beeswax. The Comparative Example 1 preparation scheme was used to incorporate the Additive A3 in the ink base components before the addition of pigment with all other process steps remaining the same such as to realize the composition shown in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 4

Preparation of Ink with Hyper-Branched Polyolefin. The Comparative Example 1 preparation was further diluted with Additive A4 such as to realize the composition shown in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 5

Preparation of Ink with Hyper-Branched Polyolefin. The Comparative Example 1 preparation scheme was used to incorporate the Additive A5 in the ink base components before the addition of pigment with all other process steps remaining the same such as to realize the composition found in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 6

Preparation of Ink with Ethoxylated Long Chain Alcohol. The Comparative Example 1 preparation was further diluted with Additive A6 such as to realize the composition found in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 7

Preparation of Ink with Ethoxylated Long Chain Alcohol. The Comparative Example 1 preparation scheme was used to incorporate the Additive A7 in the ink base components before the addition of pigment with all other process steps remaining the same such as to realize the composition found in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 8

Preparation of Ink with Long Chain Alcohol. The Comparative Example 1 preparation was further diluted with Additive A8 such as to realize the composition found in Table 3. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

### Example 9

Preparation of Ink with Hyper-Branched Polyolefin. The Comparative Example 1 preparation scheme was used to incorporate the Additive A5 in the ink base components before the addition of pigment with all other process steps remaining the same such as to realize the composition found in Table 3 having approximately twice the amount of Additive compared to the Example 5 ink. The thoroughly mixed component mixture was then qualitatively transferred to a 3-roll mill apparatus manufactured by Kent Machine Works where the material composite paste was passed through the 3-roll mill first at an input apron roll speed of 200 RPM for the first and only pass.

**Table 3**

| **Component** | **Comparative Example 1 (Weight %)** | **Examples 2 and 3 (Weight %)** | **Examples 4, 5, 6,7, and 8 (Weight %)** | **Example 9 (Weight %)** |
|---|---|---|---|---|
| Clariant C.I. Pigment Red 57:1 | 15.57 | 15.00 | 15.00 | 15.00 |
| Claytone® HY, Southern Clay Products | 2.08 | 2.00 | 2.00 | 2.00 |
| Solsperse™ J-180, The Lubrizol Corporation | 6.23 | 6.00 | 6.00 | 6.00 |
| SR-501, Sartomer Co. | 4.20 | 4.05 | 4.22 | 4.15 |
| CN294E, Sartomer Co. | 62.15 | 59.92 | 62.49 | 61.47 |
| Irgacure® 379, BASF | 2.08 | 2.00 | 2.00 | 2.00 |
| Irgacure® 819, BASF | 2.50 | 2.40 | 2.40 | 2.40 |
| Irgacure® 184, BASF | 0.50 | 3.50 | 3.50 | 3.50 |
| Esacure® KIP 150, Lamberti S.p.A. | 3.65 | 0.48 | 0.48 | 0.48 |
| CN3216, Sartomer Co. | 1.04 | 1.00 | 1.00 | 1.00 |
| Additive | 0 | 3.65 | 0.91 | 2.00 |

### Rheology Determination.

The rheologies of the Example inks were determined using an RFS-3 controlled-strain rheometer from Rheometric Scientific (now TA Instruments) at 45 °C equipped with 25 mm parallel plate assembly and run using dynamic mode to generate an ink rheology profile from 0.1 to 100 rad/s. The rheologies of the inks were also determined using a DHR-2 controlled-stress/strain rheometer (TA Instruments) at 25 °C equipped with 25 mm parallel plate assembly and run using dynamic mode to generate an ink rheology profile from 0.1 to 100 rad/s. A summary of the results is shown in Table 4.

### Tack Determination.

The tack profiles of the Example inks were determined using an Inkometer tack meter from Thwing-Albert. The inkometer was equilibrated at 32 °C where 1.32 milliliters of ink were placed on the distribution roller with the settings of the test allowing the ink to spread to the other 2 rolls of the instrument before the roller RPM increased to 1200 RPM for 10 minutes where tack measurements were taken over 20 second intervals for that 10 minute period. A summary of the tack results are shown in Table 4.

**Table 4**

| **Ink** | **Complex Viscosity at 100 rad/s at 45 °C, mPa.s** | **Complex Viscosity at 1 rad/s at 25 °C, mPa.s** | **Mean tack from 60 to 600 s, g-m** | **Tack at 60 s, g-m** |
|---|---|---|---|---|
| Comparative Example 1 | 3.18E+04 | 2.55E+05 | 46.3 | 55.2 |
| Example 2 | 8.55E+04 | 7.78E+05 | 45.5 | 51.3 |
| Example 3 | 8.54E+04 | 1.08E+05 | 42.7 | 51.3 |
| Example 4 | 4.04E+04 | 2.26E+05 | 43.3 | 50.3 |
| Example 5 | 3.47E+04 | 2.95E+05 | 40.7 | 46.6 |
| Example 6 | 2.60E+04 | 2.72E+05 | 43.8 | 50.2 |
| Example 7 | 2.58E+04 | 2.19E+05 | 43.8 | 49.7 |
| Example 8 | 3.20E+04 | 2.45E+05 | 43.4 | 49.0 |
| Example 9 | n/a | 2.98E+05 | 45.4 | 52.3 |

### Transfer of Inks onto Substrate and Radiation Curing.

Each of the inks were transferred onto Sterling® Gloss paper at different densities such that the resultant visible optical densities ranged between 1.45 and 1.55 and such that the L* brightness of the transferred images were in a range suitable for 100% magenta fill after having been cured at 1 m/s using a Fusion UV Light Hammer® L6 curing station equipped with D bulb and such that the applied energy doses for UVV, UVA, UVB, and UVC bands were 119, 274, 81, and 6 mJ/cm², respectively. The print image dimensions were on the order of 3 centimeters by 5 centimeters.

Measurement of color can, for example, be characterized by CIE (Commission International de I'Eclairage) specifications, commonly referred to as CIELAB, where L*, a* and b* are the modified opponent color coordinates, which form a 3 dimensional space, with L* characterizing the lightness of a color, a* approximately characterizing the redness, and b* approximately characterizing the yellowness of a color.

### MEK Rub Testing.

A soft applicator dipped in methylethyl ketone (MEK) solvent at room temperature was spread evenly across (about 2 centimeters) each of the images on Xerox® Digital Color Elite Gloss® (DCEG) paper using constant pressure with fresh MEK being reapplied onto the applicator every 5 double MEK rubs. The number of MEK double rubs required before the paper substrate becomes visible is recorded with the number of double MEK rubs. A summary of the results is shown in Table 5. Higher MEK double rubs are preferred indicating better solvent resistance to MEK.

### Cross-Hatch Adhesion Testing of Prints.

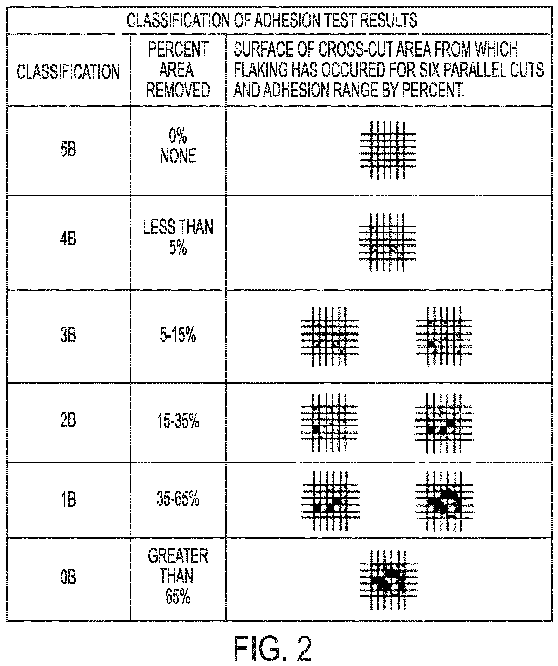

After 24 hours following curing with the Fusion UV Light Hammer® L6 curing station, the relative adhesion quality of the print was determined using the method prescribed in ASTM D-3359, "Measuring Adhesion by Tape test," using Elcometer® 99 tape available from Elcometer® USA. The rating system in ASTM D3359 is shown in Figure 2 and ranges from 0B to 5B where at least 3B adhesion results are preferred and 5B adhesion results are most preferred. The summary of adhesion test results of the prints made from the Example inks is shown in Table 5.

### Determination of Coloristic Properties.

A spectrodensitometer X-Rite 538 was used to measure the color properties of some of the ink images using D50 and 2° settings. Each of the images was measured 3 times with the mean data reported in Table 5.

**Table 5**

| **Ink Example** | **MEK Double Rubs** | **Adhesion Rating (ASTM D-3359)** | **L*** | **a*** | **b*** |
|---|---|---|---|---|---|
| Comparative Example 1 | 12 | 3B | 46.91 | 76.56 | -5.25 |
| Example 2 | 12 | 4B+ | 46.38 | 76.08 | -3.64 |
| Example 4 | 9 | n/a | 44.92 | 72.88 | 3.39 |
| Example 5 | 16 | 3B | 47.70 | 78.37 | -6.59 |
| Example 6 | 20 | 4B- | 45.42 | 74.88 | 3.42 |
| Example 8 | 21 | 4B- | 46.37 | 77.27 | -3.75 |
| Example 9 | 26 | 3B | 46.21 | 76.43 | -5.43 |

The MEK double rub and cross-hatch tests are severe stress tests for any print or coating. Prints having higher solvent resistance such as against MEK, methyl isobutyl ketone (MIBK), acetone, xylene, toluol (such as 1:9 MEK:Toluene by weight), and the like, indicate a higher level of cure and significant cross-linking density of the ink on the print. Prints having sufficient resistance against these solvents generally are more robust towards everyday fluids such as water, coffee, juice, soap, oils, and fats, etc. The cross-hatch test, such as described in ASTM D-3359, involves placing a cross-hatch pattern in the imaged, cured ink such that multiple stress points are formed where the cured ink on the print can be taken up from the tape as it is being first placed on the image then removed.

The print robustness results shown in Table 5 indicate that the addition of several non-radiation curable additives to radiation curable DALI inks yields prints that are more robust to MEK solvent and/or have higher adhesion compared to prints made from radiation curable DALI inks without these additives. Example 9, having about twice the amount Additive A5 in it compared to Example 5, had higher resistance against MEK rubs but the same adhesion.

Thus, DALI radiation curable ink compositions, in embodiments, UV curable ink compositions, comprising non-radiation curable additives as described herein afford more robust prints with respect to solvent resistance and/or adhesion.

## Claims

1. An ink composition for use in digital offset printing, comprising:
at least one component selected from the group consisting of a curable monomer and a curable oligomer;
an optional colorant;
an optional dispersant;
an optional photoinitiator; and
at least one non-radiation curable additive, wherein the non-radiation curable additive is a solid at a temperature of from about 20 °C to about 40 °C.

2. The ink composition of claim 1, wherein the at least one non-radiation curable additive is a solid at a temperature of from about 20 °C to about 30 °C.

3. The ink composition of claim 1, wherein the at least one non-radiation curable additive is selected from the group consisting of carnauba wax, beeswax, higher molecular weight ester wax having a molecular weight of from about 300 to about 900, hydrocarbon based olefin, long chain ether having from about 20 to about 60 carbon atoms, ethoxylated long chain alcohol having from about 24 to about 44 carbon atoms, long chain fully saturated primary alcohol having from about 20 to about 60 carbon atoms, and combinations thereof.

4. The ink composition of claim 1, wherein the at least one non-radiation curable additive is selected from the group consisting of long chain fully saturated primary alcohol having from about 28 to about 60 carbon atoms, long chain ether having from about 28 to about 60 carbon atoms, and combinations thereof.

5. The ink composition of claim 1, wherein the at least one non-radiation curable additive comprises a paraffin having from about 24 to about 28 carbon atoms.

6. The ink composition of claim 1, wherein the at least one non-radiation curable additive comprises a paraffin having greater than about 28 carbon atoms.

7. The ink composition of claim 1, wherein the at least one non-radiation curable additive comprises a wax having a melting point of less than about 100 °C.

8. The ink composition of claim 1, wherein the at least one non-radiation curable additive comprises poly(maleic anhydride-alt-olefin C24-C28).

9. The ink composition of claim 1, wherein the at least one non-radiation curable additive is present in the ink composition in an amount of from about 1 to about 6 percent by weight based upon the total weight of the ink composition.

10. The ink composition of claim 1, wherein the at least one component selected from the group consisting of a curable monomer and a curable oligomer is a component selected from the group consisting of acrylated polyesters, acrylated polyethers, acrylated epoxies, urethane acrylates, and pentaerythritol tetraacrylate, and combinations thereof.

11. The ink composition of claim 1, wherein the at least one component selected from the group consisting of a curable monomer and a curable oligomer is a component selected from the group consisting of a tetrafunctional polyester acrylate oligomer, a propoxylated trimethylolpropane triacrylate monomer, and combinations thereof.

12. The ink composition of claim 1, further comprising a clay; and wherein the colorant is a pigment.

13. A process of digital offset printing, the process comprising:
applying an ink composition onto a re-imageable imaging member surface at an ink take up temperature, the re-imageable imaging member having dampening fluid disposed thereon;
forming an ink image;
transferring the ink image from the re-imageable surface of the imaging member to a printable substrate at an ink transfer temperature;
wherein the ink composition comprises:
at least one component selected from the group consisting of a curable monomer and a curable oligomer;
an optional colorant;
an optional dispersant;
an optional photoinitiator; and
at least one non-radiation curable additive, wherein the non-radiation curable additive is a solid at a temperature of from about 20 °C to about 40 °C.

14. The process of claim 13, wherein applying the ink composition comprises applying the ink composition using an anilox delivery system.

15. The process of claim 13, wherein the at least one non-radiation curable additive is selected from the group consisting of carnauba wax, beeswax, higher molecular weight ester wax having a molecular weight of from about 300 to about 900, hydrocarbon based olefin, long chain ether having from about 20 to about 60 carbon atoms, ethoxylated long chain alcohol having from about 24 to about 44 carbon atoms, long chain fully saturated primary alcohol, having from about 20 to about 60 carbon atoms, and combinations thereof.

16. The process of claim 13, wherein the at least one non-radiation curable additive is present in the ink composition in an amount of from about 1 to about 6 percent by weight based upon the total weight of the ink composition.

17. A process comprising:
combining at least one component selected from the group consisting of a curable monomer and a curable oligomer; an optional colorant; an optional dispersant; an optional photoinitiator; and at least one non-radiation curable additive, wherein the non-radiation curable additive is a solid at a temperature of from about 20 °C to about 40 °C;
optionally, heating; and
optionally, filtering;
to provide an ink composition.

18. The process of claim 17, wherein the at least one non-radiation curable additive is selected from the group consisting of carnauba wax, beeswax, higher molecular weight ester wax having a molecular weight of from about 300 to about 900, hydrocarbon based olefin, long chain ether having from about 20 to about 60 carbon atoms, ethoxylated long chain alcohol having from about 24 to about 44 carbon atoms, long chain fully saturated primary alcohol, having from about 20 to about 60 carbon atoms, and combinations thereof.

19. The process of claim 17, wherein the at least one non-radiation curable additive is present in the ink composition in an amount of from about 1 to about 6 percent by weight based upon the total weight of the ink composition.

20. The process of claim 17, wherein the at least one component selected from the group consisting of a curable monomer and a curable oligomer is a component selected from the group consisting of acrylated polyesters, acrylated polyethers, acrylated epoxies, urethane acrylates, and pentaerythritol tetraacrylate, and combinations thereof.
